## Europäisches Patentamt

## European Patent Office

## Office européen des brevets

(19)

(11) Publication number: **0 186 976 B1**

# EUROPEAN PATENT SPECIFICATION

(12)

(45) Date of publication of patent specification: **27.02.91**  (51) Int. Cl.5: **H01L 21/316**

(21) Application number: **85308733.6**

(22) Date of filing: **02.12.85**

(54) **Forming glass layers on semiconductor substrates.**

(30) Priority: **12.12.84 GB 8431525**

(43) Date of publication of application:
**09.07.86 Bulletin 86/28**

(45) Publication of the grant of the patent:
**27.02.91 Bulletin 91/09**

(84) Designated Contracting States:
**AT BE CH DE FR IT LI LU NL SE**

(56) References cited:

EXTENDED ABSTRACTS, vol. 85, no. 2, October 1985, pages 382-383, abstract no. 255, Pennington, New Jersey, US; J.R. GIGANTE et al.: "Rapid reflow of borophosphosilicate glass"

EXTEND ABSTRACTS, vol. 85, no. 2, October 1985, page 373, abstract no. 249, Pennington, New Jersey, US; N.S. ALVI et al.: "Reflow of PSG by rapid thermal annealing"

SOLID STATE TECHNOLOGY, vol. 28, no. 6, June 1985, pages 185-190, Port Washington, New York, US; S.R. WILSON et al.: "Rapid annealing technology for future VLSI"

(73) Proprietor: **STC PLC**
**10, Maltravers Street**
**London, WC2R 3HA(GB)**

(72) Inventor: **Scovell, Peter Denis**
**14 Staplecroft Spring Field**
**Chelmsford Essex(GB)**
Inventor: **Jennings, Stephen Robert**
**43 Ashdale**
**Bishops Stortford Hertfordshire(GB)**

(74) Representative: **Ryan, John Peter William et al**
**STC Patents West Road**
**Harlow Essex CM20 2SH(GB)**

JOURNAL OF THE ELECTROCHEMICAL SOCI-
ETY, vol. 132, no. 1, January 1985, pages
141-145, Manchester, New Hampshire, US;
R.A. BOWLING et al.: "Deposition and reflow
of phosphosilicate glass"

SOLID STATE TECHNOLOGY, vol. 26, no. 10,
October 1983, pages 217-224, Port Washing-
ton, New York, US; I. AVIGAL: "Inter-metal
dielectric and passivation-related properties
of plasma BPSG"

Solid State Technology, vol.26, no.11, No-
vember 1983, page 92

## Description

This invention relates to a method of reflowing a glass insulating layer on a semiconductor surface.

With decreasing device geometries the problems associated with surface topography of an integrated circuit are becoming increasingly difficult to overcome. In particular there is a need to planarise the circuit surface prior to the application of the metallisation to avoid the risk of incomplete step coverage. This problem is becoming particularly acute with the present trend towards a very high density of integration. Planarising surface coatings have been employed but, as device geometries become smaller, it has become difficult to provide adequately profiled contact openings. To avoid a sharp step around such openings, etches have been employed which form a tapered profile at the periphery of each opening. However, unless etching is very carefully controlled, there is considerable risk of 'overblowing' of the contact opening.

Attempts have been made to overcome this problem by the provision of a surface glass layer that is etched to provide contact openings and is then flowed across the device surface by heating to a temperature at which the glass becomes fluid thus profiling the edges of the contact openings. Typically a 30 minutes bake at $1000\degree$ C is required for this purpose. However this treatment then has an adverse effect on the device as a result of dopant redistribution. Again this problem is accentuated by the small device dimensions involved. The problem of dopant redistribution has been overcome by pulse heating techniques. In a typical prior art process, such as that described in UK specification No. 2126418 A, a semiconductor circuit is coated with a phosphate glass and is then pulse heated in vacuum for a period, typically 8 to 15 sec. sufficient to cause softening and flow of the glass. Whilst this technique is suitable for single planarising coatings it cannot readily be applied to structures using a plurality of metallisation levels. During the vacuum heating process phosphorus pentoxide is lost from the glass by evaporation. This significantly raises the softening point of the glass. Any subsequent reflow then requires a substantially higher processing temperature which may damage either the circuit or a deposited metallisation layer. It will also be appreciated that vacuum techniques are not readily compatible with processes requiring a high throughput rate.

The object of the present invention is to minimise or to overcome this disadvantage.

According to one aspect of the invention there is provided a contact to an integrated circuit, the method including providing an insulating layer on the circuit, etching a contact opening in the insulating layer to expose a contact region on the circuit, profiling or smoothing the edge of the contact opening, and applying a metal contact to the circuit via the opening, wherein the insulating layer comprises a phosphosilicate glass and the glass is planarised via a first reflow, characterised in that, after etching the contact opening, the glass is subjected to a second reflow by heating to a temperature above that at which the glass becomes fluid for a period of 10 to 20 seconds whereby to profile or smooth the edges of the contact opening.

The pulse heating process is performed at ambient pressure in a controlled atmosphere which may be active or inert. We have found for example that the inclusion of oxygen or water in the atmosphere provides increased flow of the glass and hence increased planarisation for the same anneal time and temperature. Thus, prior to the contact hole etch, an oxygen or steam containing atmosphere can be used for transient reflow. By using two reflows it is possible to planarise the surface topography and round the contact hole edges thereby improving step coverage and yield. The degree of reflow is determined by control of the atmosphere in which the reflow is performed. Thus, for a given peak temperature, reflow is enhanced by the use of an oxidising atmosphere, e.g. oxygen or steam. We have found that oxygen reduces the softening temperature by $25\degree$, and steam reduces the temperature by $50\degree$.

Embodiments of the invention will now be described with reference to the accompanying drawings in which:-

Figs. 1 to 4 illustrate successive stages in the fabrication of an integrated circuit;

Figs. 5 and 6 illustrate the effects of conventional heat treatment and thermal pulse heating on dopant redistribution.

and Figs. 7 and 8 illustrate the effect of reflow on contact hole sidewall angle and step planarisation respectively.

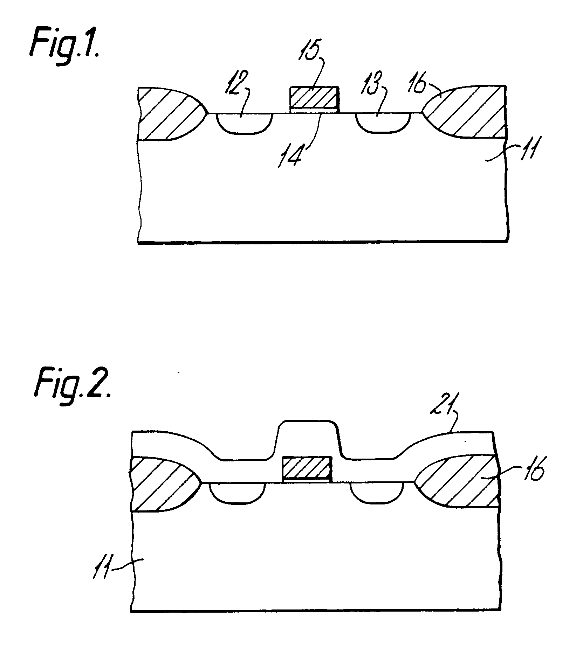

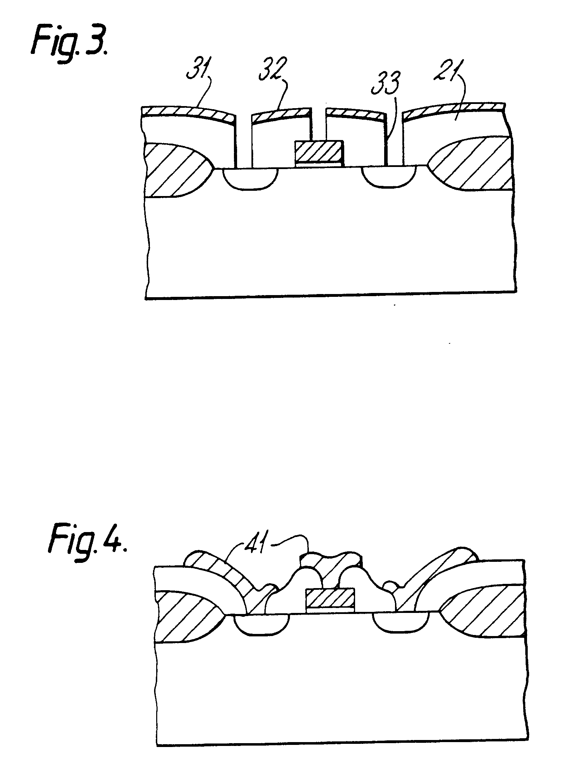

Referring to Fig. 1 to 3, the circuit is formed on e.g. a silicon substrate 11 (Fig. 1) and may comprise a plurality of transistors having doped drain and source regions, 12 and 13 respectively, separated by a gate region. The gate comprises an insulator film 14 and a polysilicon electrode 15. The transistor is surrounded by a wall 16 of oxide. The device is provided with a surface layer 21 (Fig. 2) of a glass, typically by a chemical vapour deposition process. For this purpose we prefer to employ an 8% phosphosilicate glass deposited from a gaseous mixture of silane, phosphine and oxygen. This glass is a silica glass containing 8 weight % of phosphorus. Typically this glass layer 21 is about 8000 A (0.8 microns) in thickness. The glass as deposited follows the contours of the substrate surface. To provide a smooth surface for subsequent processing the glass 21 is subjected to a first reflow by pulse heating the structure in an atmosphere comprising e.g. oxygen, steam or mixtures thereof to a peak temperature of 1050 to 1075°C, typically for a period of 10 to 30 seconds. The assembly is then cooled and provided with a mask 31 (Fig. 3) having openings 32 defining the positions of the device contacts. Contact openings 33 in the glass 21 are formed by plasma etching through the mask 31. For this purpose we prefer to employ a mixture of oxygen and a fluorine containing vapour. Typically we employ oxygen and a mixture of $CHF_3$ and $C_2F_6$. The contact holes 33 etched through the glass layer 21 expose the source, drain and gate of the transistor.

After contact hole etching the glass surface is smoothed and the contact hole edges rounded by a second reflow of the glass 21. This is effected by pulse heating the device to a temperature of about 1100°C, i.e. about 100°C to 150°C above the glass softening point, for 10 to 20 seconds in an inert atmosphere, typically comprising nitrogen. The two reflows have been found to provide adequate surface smoothing without effecting significant dopant redistribution. For each reflow heating may be effected by irradiation from an infra-red halogen lamp.

After the second reflow of the glass has been effected metallisation 41 (Fig. 4) is applied to contact the drain, source and gate. Typically the metallisation comprises aluminium or an aluminium alloy.

Although we prefer to employ a phosphosilicate glass the technique is not so limited. For example, borophosphosilicate, phosphogermanosilicate and arsenosilicate glasses may also be used.

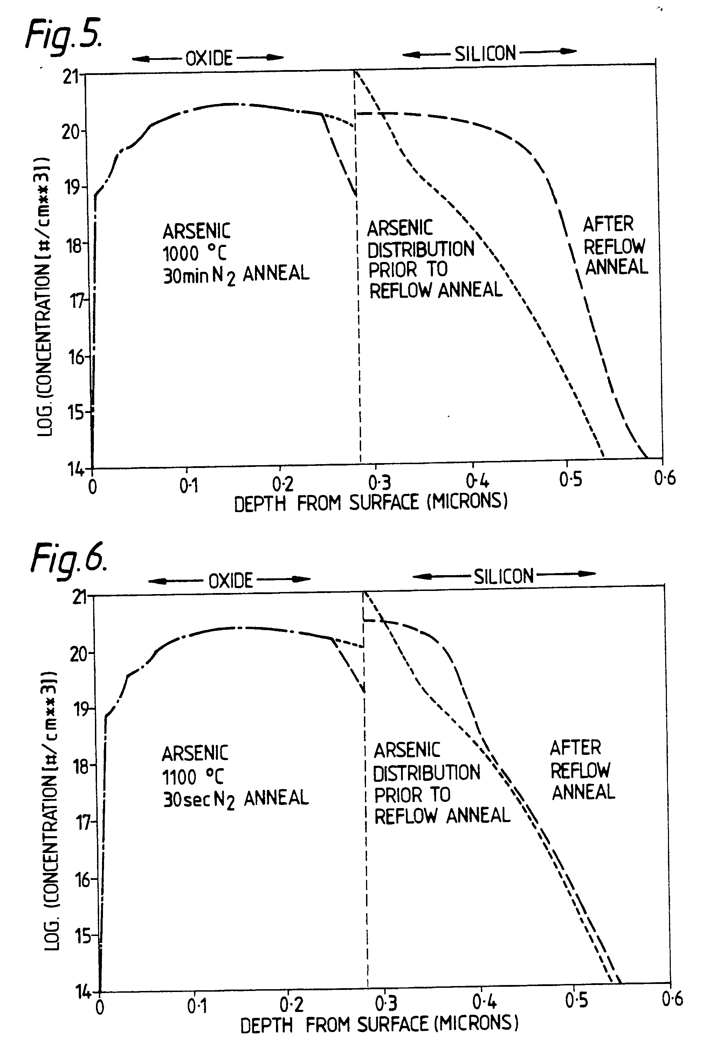

The advantage of pulse heating over conventional furnace processing is illustrated in Figs. 5 and 6 which show computer simulations of dopant redistribution for those two techniques. The two figures model the distribution of an arsenic dopant in a surface oxide and in the underlying silicon. As can be seen from Fig. 6 the redistribution of arsenic resulting from the pulse heating process is insignificant.

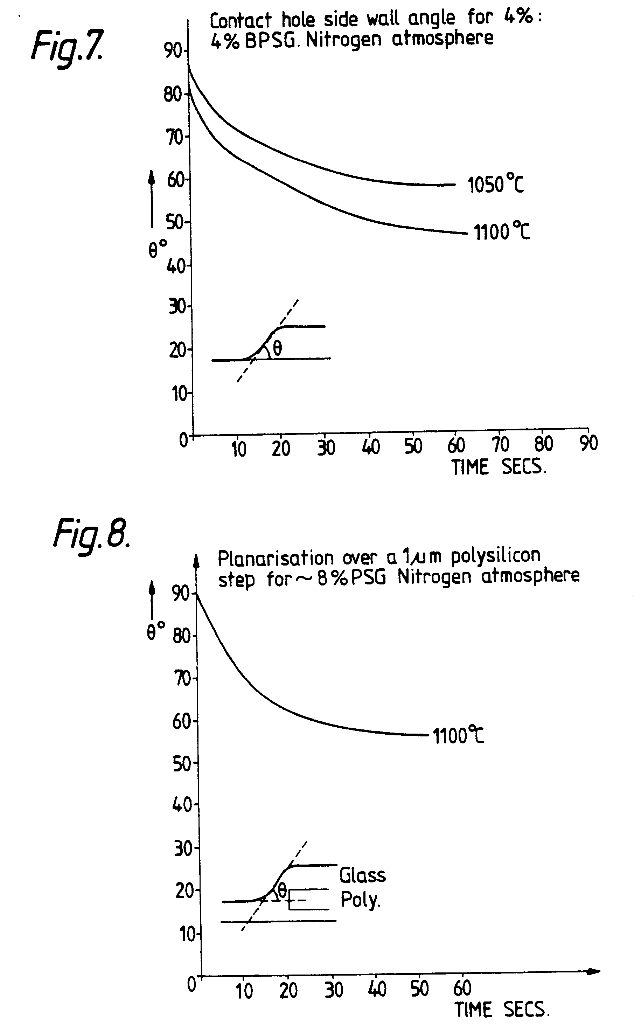

To illustrate the technique described herein, an 8% phosphosilicate glass was deposited over nonplanar topography to investigate the planarisation of the glass as a function of anneal conditions. Contact holes were cut into the glass using an anisotropic etch and reflowed. The effect of the temperature and duration of anneal on the contact hole profile was studied by scanning electron microscopy. A similar series of experiments has been conducted on 4% 4% borophosphosilicate glass. This glass contained 4 weight % phosphorus and 4 weight % boron. The results of these tests are summarised in Figs. 7 and 8.

Contact chains have been produced using transiently reflowed phosphosilicate glass and borophosphosilicate glass. Metal step coverage and contact resistance were investigated and compared to traditional reflow schedules. Both $n^+$ and $p^+$ diodes with $x_j \sim 3000$ Å were fabricated to investigate the effect of the transient anneal on junction characteristics. After a total anneal time of 45 seconds at 1100°C the junction leakage is typically less than 10 $nAcm^{-2}$ for both types of junction. The transient reflow has the additional benefit of fully activating all dopants. Sheet resistivities typically of 40 ohms per square have been obtained for both $n^+$ arsenic junctions and $p^+$ boron junctions.

These results indicate the compatibility of a transient reflow with a 2 micron CMOS technology.

As the pulse heating technique is transient, shallow junctions are substantially unaffected and improved device performance is thus obtained. Also the technique has the advantage of activating the doped layers in an advanced VLSI structure. Thus a single anneal can be used both to activate implanted species and to reflow the contact holes.

## Claims

1. A method of providing a contact to an integrated circuit, the method including providing an insulating layer on the circuit, etching a contact opening in the insulating layer to expose a contact region on the circuit, profiling or smoothing the edge of the contact opening, and applying a metal contact to the circuit via the opening, wherein the insulating layer comprises a phosphosilicate glass and the glass is planarised via a first reflow, characterised in that, after etching the contact opening, the glass is subjected to a second reflow by heating to a temperature above that at which the glass becomes fluid for a period of 10 to 20 seconds whereby to profile or smooth the edges of the contact opening.

2. A method as claimed in claim 1, characterised in that the first reflow is performed in an atmosphere of oxygen or steam.

3. A method as claimed in claim 1 or 2, characterised in that the second reflow effecting contact smoothing is performed in an inert atmosphere.

4. A method as claimed in claim 1, 2 or 3 characterised in that the second reflow effecting contact smoothing is performed at a temperature of 100°C above the melting temperature of the glass.

## Revendications

1. Procédé de formation d'un contact dans un circuit intégré, le procédé comprenant la formation d'une couche isolante sur le circuit, l'attaque d'une ouverture de contact dans la couche isolante afin qu'une région de contact soit exposée sur le circuit, le profilage ou le lissage du bord de l'ouverture de contact, et l'application d'un contact métallique sur le circuit par l'intermédiaire de l'ouverture, dans lequel la couche isolante est un verre de phosphosilicate et le verre est rendu plan par une première refusion, caractérisé en ce que, après l'attaque de l'ouverture de contact, le verre est soumis à une seconde refusion par chauffage à une température supérieure à laquelle le verre devient fluide, pendant une période de 10 à 20 s, afin que les bords de l'ouverture de contact soient profilés ou lissés.

2. Procédé selon la revendication 1, caractérisé en ce que la première refusion est réalisée en atmosphère d'oxygène ou de vapeur d'eau.

3. Procédé selon la revendication 1 ou 2, caractérisé en ce que la seconde refusion assurant le lissage des contacts est réalisée en atmosphère inerte.

4. Procédé selon la revendication 1, 2 ou 3, caractérisé en ce que la seconde refusion réalisant le lissage des contacts est réalisée à une température supérieure de 100°C à la température de fusion du verre.

## Ansprüche

1. Verfahren zur Herstellung eines Kontaktes an eine integrierte Schaltung, wobei das Verfahren die Schritte der Schaffung einer Isolierschicht auf der Schaltung, das Ätzen einer Kontaktöffnung in der Isolierschicht zum Freilegen eines Kontaktbereiches auf der Schaltung, der Profilierung oder Glättung der Kante der Kontaktöffnung und des Aufbringens eines Metallkontaktes an die Schaltung über die Öffnung einschließt, wobei die Isolierschicht ein Phosphorsilicatglas umfaßt und das Glas über ein erstes Aufschmelzen eingeebnet wird, dadurch gekennzeichnet, daß das Glas nach dem Ätzen der Kontaktöffnung einem zweiten Aufschmelzen durch Erwärmen auf eine Temperatur oberhalb der Temperatur, bei der das Glas flüssig wird, für eine Zeitperiode von 10 bis 20 Sekunden unterworfen wird, um auf diese Weise die Kanten der Kontaktöffnung zu profilieren oder zu glätten.

2. Verfahren nach Anspruch 1, dadurch **gekennzeichnet**, daß das erste Aufschmelzen in einer Atmosphäre von Sauerstoff oder Dampf durchgeführt wird.

3. Verfahren nach Anspruch 1 oder 2, dadurch **gekennzeichnet**, daß das zweite Aufschmelzen, das die Kontaktglättung bewirkt, in einer inerten Atmosphäre ausgeführt wird.

4. Verfahren nach Anspruch 1, 2 oder 3, dadurch **gekennzeichnet**, daß das zweite Aufschmelzen, das die Kontaktglättung bewirkt, bei einer Temperatur von 100° oberhalb der Schmelztemperatur des Glases durchgeführt wird.

**Fig.1.**

**Fig.2.**

## Fig. 3.

## Fig. 4.

Fig.5.

OXIDE ← → ← SILICON →

LOG. (CONCENTRATION [#/cm**3])

ARSENIC
1000 °C
30min N$_2$ ANNEAL

ARSENIC
DISTRIBUTION
PRIOR TO
REFLOW ANNEAL

AFTER
REFLOW
ANNEAL

DEPTH FROM SURFACE (MICRONS)

Fig.6.

← OXIDE → ← SILICON →

LOG. (CONCENTRATION [#/cm**3])

ARSENIC
1100 °C
30sec N$_2$ ANNEAL

ARSENIC
DISTRIBUTION
PRIOR TO
REFLOW ANNEAL

AFTER
REFLOW
ANNEAL

DEPTH FROM SURFACE (MICRONS)

**Fig.7.**

Contact hole side wall angle for 4%: 4% BPSG. Nitrogen atmosphere

**Fig.8.**

Planarisation over a 1 μm polysilicon step for ~8% PSG Nitrogen atmosphere